# EUROPEAN PATENT SPECIFICATION

(11) **EP 1 788 603 B1**
(45) Date of publication and mention of the grant of the patent: **05.05.2010**
(21) Application number: 06122879.7
(22) Date of filing: 24.10.2006
(51) Int. Cl.: H01H 57/00, H01H 59/00, H01P 1/12

(54) **RF MEMS switch and method for fabricating the same**
HF MEMS Schalter und zugehöriges Herstellungsverfahren
Commutateur RF MEMS et procédé de fabrication correspondant

(30) Priority: 21.11.2005 KR 20050111380
(43) Date of publication of application: 23.05.2007
(73) Proprietor: Samsung Electronics Co., Ltd., Suwon-si, Gyeonggi-do (KR)
(72) Inventor: Kim, Jong-seok, Taen-gu, Hwaseong-si, Gyeonggi-do (KR); Kwon, Sang-wook, Bundang-gu, Seongnam-si, Gyeonggi-do (KR); Kim, Dong-kyun, Suwon-si, Gyeonggi-do (KR); Kim, Che-heung, Gyeonggi-do (KR); Lee, Sang-hun, Seocho-gu, Seoul (KR); Houng, Young-tack, c/o Samsung Adv. Inst. of Techn, Gyunggi-do 449-712 (KR); Lee, Chang-seung, Gyeonggi-do (KR); Song, In-sang, Gwanak-gu, Seoul (KR)
(74) Representative: Ertl, Nicholas Justin

(56) References cited:
- WO-A-94/19819
- WO-A-2005/022575
- DE-A1- 10 031 569
- DE-A1- 10 152 945
- DE-C1- 4 205 029
- JP-A- 57 115 735
- JP-A- 57 115 736
- US-A- 4 595 855
- US-A- 6 100 477
- PETERSEN K E: "MICROMECHANICAL MEMBRANE SWITCHES ON SILICON" IBM JOURNAL OF RESEARCH AND DEVELOPMENT, INTERNATIONAL BUSINESS MACHINES CORPORATION, NEW YORK, NY, US, vol. 23, no. 4, 1 July 1979 (1979-07-01), pages 376-385, XP000605011 ISSN: 0018-8646
- PETERSEN K E: "DYNAMIC MICROMECHANICS ON SILICON: TECHNIQUES AND DEVICES" IEEE TRANSACTIONS ON ELECTRON DEVICES, IEEE SERVICE CENTER, PISACATAWAY, NJ, US, vol. 25, no. 10, October 1978 (1978-10), pages 1241-1249, XP000965249 ISSN: 0018-9383

## Description

### BACKGROUND OF THE INVENTION

The present invention relates to a method for fabricating a radio frequency Microelectromechanical System (RF MEMS) switch. More particularly, the present invention relates to a method for fabricating an RF MEMS switch and an RF MEMS switch fabricated by the method, in which the RF MEMS device is down bent at a low voltage.

Generally, an RF MEMS switch is used in various fields. For example, an RF MEMS device is used as a band selector, a multi-function switch, or a phase shifter in mobile products.

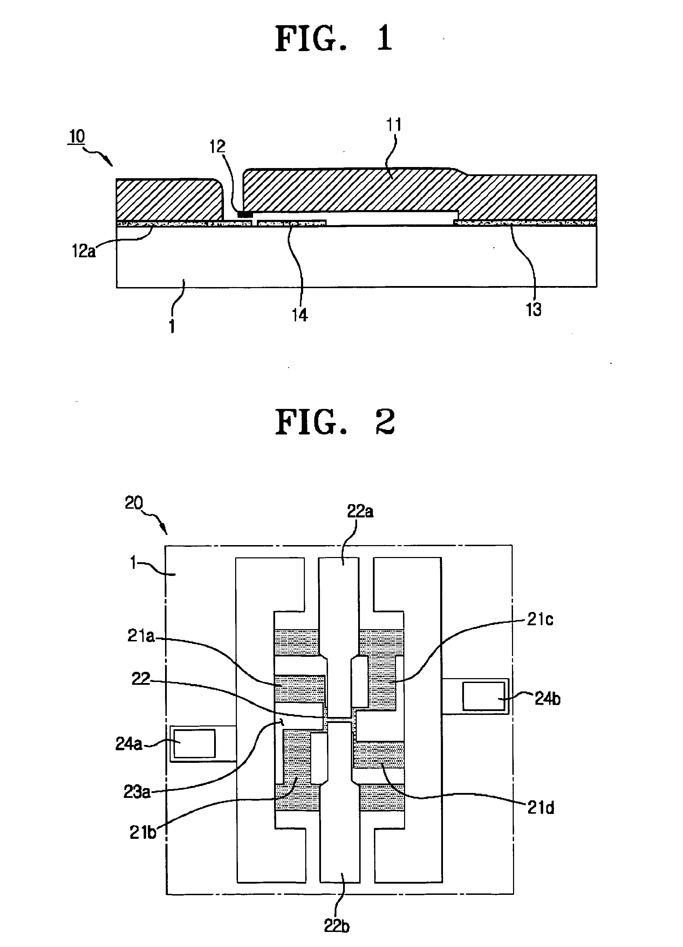

Various kinds of RF MEMS switches have been developed. Examples of an RF MEMS switch include an electrostatic RF MEMS switch based on electrostatic phenomenon and a piezoelectric RF MEMS switch based on piezoelectric effect. FIGS. 1 and 2 respectively show these RF MEMS switches.

FIG. 1 is a front sectional view illustrating an electrostatic RF MEMS switch. Referring to FIG. 1, the electrostatic RF MEMS switch 10 includes a substrate 1 provided with an RF signal line 12a, an anchor 13, and a driving line 14, a cantilever 11 fixed to the anchor 13 at an interval of 1 µm from the RF signal line 12a, and a contact pad 12 formed at an end of the cantilever 11 to be switched on/off in contact with the RF signal line 12a in accordance with driving of the cantilever 11. If an external voltage is applied to the RF MEMS switch 10 through the driving line 14, electrostatic force occurs between the driving line 14 and the cantilever 11, so that the cantilever 11 is down driven to allow the contact pad 12 to transmit an RF signal in contact with the RF signal line 12a. However, the electrostatic RF MEMS switch 10 has a high driving voltage of 3V or greater and a high volume. Because of this, the general trend is to substitute the electrostatic RF MEMS device with a piezoelectric RF MEMS switch shown in FIG. 2.

FIG. 2 is a plan view illustrating a piezoelectric RF MEMS switch. Referring to FIG. 2, an RF MEMS switch 20 of lead zirconate titanate (PZT, Pb(Zr,Ti)O₃), which is up driven, is shown. The piezoelectric RF MEMS switch 20 includes a substrate 1 plated with an RF input signal line 22a and an RF output signal line 22b, and a plurality of cantilevers 21a to 21d that support a contact pad 22 positioned below the RF signal lines 22a and 22b and spaced apart from the RF signal lines 22a and 22b. The cantilevers 21a to 21d comprise an upper electrode layer, a piezoelectric layer, a lower electrode layer, and a membrane. If a DC voltage is applied to the electrode layers of the cantilevers 21a to 21d through driving lines 24a and 24b, the cantilevers 21 a to 21 d are up bent in a cavity 23a. Then, the contact pad 22 formed at an end of the cantilevers 21 a to 21 d contacts the RF signal lines 22a and 22b so that the RF signal lines 22a and 22b are connected with each other to transmit an RF signal. The piezoelectric RF MEMS switch 20 can be driven at a voltage less than 3V, generates displacement of about 1.8µm when the cantilever has a length of 100µm, and has little power consumption.

However, there occurs some difficulty in fabricating the aforementioned piezoelectric RF MEMS switch 20. Particularly, the fabricating process of the piezoelectric RF MEMS switch 20 is not simple. In the piezoelectric RF MEMS switch 20, the piezoelectric layer or the membrane of the cantilevers is fabricated at a high temperature. For this reason, the piezoelectric layer or the membrane should be formed prior to a coplanar waveguide (CPW) line including the RF signal lines. If the CPW line is formed on the substrate and a piezoelectric thin film material is fabricated on the CPW line, diffusion of metal occurs at a high temperature or silicide is formed. Therefore, in the piezoelectric RF MEMS switch, as shown in FIG. 2, the cantilevers 21a to 21d are up bent and a separate wafer or substrate 1 is prepared on the cantilevers 21 a to 21 d so as to form the CPW line. In this case, a rear surface (bottom) of the substrate is excessively etched. In the piezoelectric RF MEMS switch 20 shown in FIG. 2, after the RF signal lines 22a and 22b are formed on the upper surface of the substrate 1 through plating, an opposite surface of the substrate 1 is fully etched so as to form the cantilevers 21a to 21d.

To solve the difficulty in fabricating the RF MEMS switch, Korean Laid-Open Patent Nos. 2005-86629 and 2005-0076149 disclose a piezoelectric RF MEMS switch in which cantilevers are formed on a cavity so that they can be down driven. However, this piezoelectric RF MEMS switch separately requires a substrate provided with cantilevers and a substrate provided with an RF signal line. In this respect, if a CPW line and cantilevers are provided on one substrate in the piezoelectric RF MEMS switch, it is possible to provide a simple fabricating process of the piezoelectric RF MEMS switch. In such case, it is easy to form the CPW line, and switching operation of the RF MEMS switch would exactly be performed.

DE 10031569 and JP57 115736 each disclose a microswitch in which a cantilever is suspended over a cavity, and is pulled down to provide a connection between signal lines.

### SUMMARY OF THE INVENTION

According to the invention, there is provided a method for fabricating an RF MEMS switch as claimed in claim 1.

The step of forming the cavity preferably includes an etching process.

The passivation layer is preferably formed of silicon oxide or silicon nitride.

The first sacrificing layer may be formed of any one of polysilicon, low temperature oxide (LTO), Tetraethylorthosilicate (TEOS), polymer for photoresist, metal, and alloy.

The upper electrode and the lower electrode are preferably formed of any one of platinum (Pt), rhodium (Rh), tantalum (Ta), gold (Au), molybdenum (Mo) and AuPt.

The piezoelectric layer may be formed of a piezoelectric material such as PZT, barium titanate, indium oxide (ITO), zinc oxide, and aluminum nitride (AlN).

The membrane layer is preferably formed of any one of silicon nitride, AlN, polysilicon oxide, TEOS, Mo, Ta, Pt, and Rh.

The RF signal lines can be formed of a conductive metal such as Au, Rh, titanium (Ti), Ta, Pt, and gold/nickel alloy (AuNix). In an exemplary embodiment, the RF signal lines are formed of Au.

In an exemplary embodiment, the step of forming the contact pad includes depositing a second sacrificing layer on the substrate provided with the RF signal lines and patterning the second sacrificing layer, forming the contact pad in the cantilever on the patterned sacrificing layer, and removing the first and second sacrificing layers.

In the method for fabricating an RF MEMS switch according to the present invention, a gap between the RF signal line and the contact pad is controlled by the thickness of the second sacrificing layer.

The second sacrificing layer may be formed of any one of polysilicon, LTO, TEOS, polymer for photoresist, metal, and alloy.

The present invention is thus directed to an RF MEMS switch and a method for fabricating the same, which addresses the problems and disadvantages of the related art. The RF MEMS switch of the invention, and fabricated by the method of the invention, can be driven at a low voltage without power consumption.

### BRIEF DESCRIPTION OF THE DRAWINGS

The above aspects and features of the present invention will be more apparent by describing certain exemplary embodiments of the present invention with reference to the accompanying drawings, in which:
FIG. 1 is a front sectional view illustrating an electrostatic RF MEMS switch;
FIG. 2 is a plan view illustrating an up driven RF MEMS switch based on PZT;
FIG. 3 is a perspective view illustrating a down driven RF MEMS switch manufactured according to the first exemplary embodiment of the present invention;
FIG. 4A is a plan view of FIG. 3;
FIG. 4B is a sectional view taken along line A-A of FIG. 4A;
FIG. 4C is a sectional view taken along line B-B of FIG. 4A;
FIG. 5 to FIG. 7 are plan views illustrating RF MEMS switches according to other exemplary embodiments;
FIG. 8 is a sectional view illustrating the operation of the RF MEMS switch according to the first exemplary embodiment of the present invention;
FIG. 9 is a graph illustrating a displacement relation between a voltage applied to the RF MEMS switch of an exemplary embodiment of the present invention and a cantilever; and
FIG. 10A to FIG. 10L illustrate a method for fabricating an RF MEMS switch according to the first exemplary embodiment of the present invention.

### DETAILED DESCRIPTION OF THE EXEMPLARY EMBODIMENTS

Reference will now be made in detail to the exemplary embodiments of the present invention, examples of which are illustrated in the accompanying drawings. Wherever possible, the same reference numbers will be used throughout the drawings to refer to the same or like parts. The invention relates to a manufacturing method and the switches manufactured by the method of the invention (referred to below as switches according to the invention).

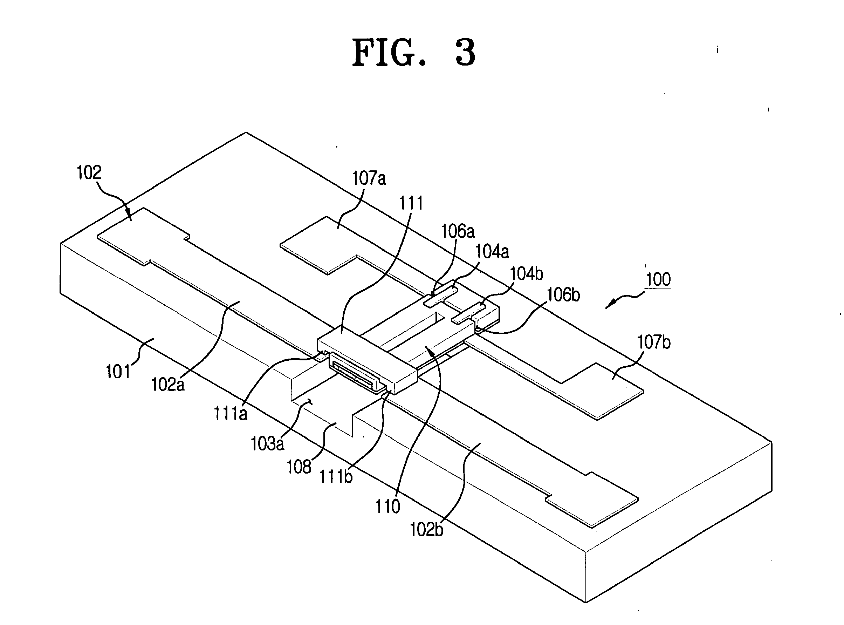

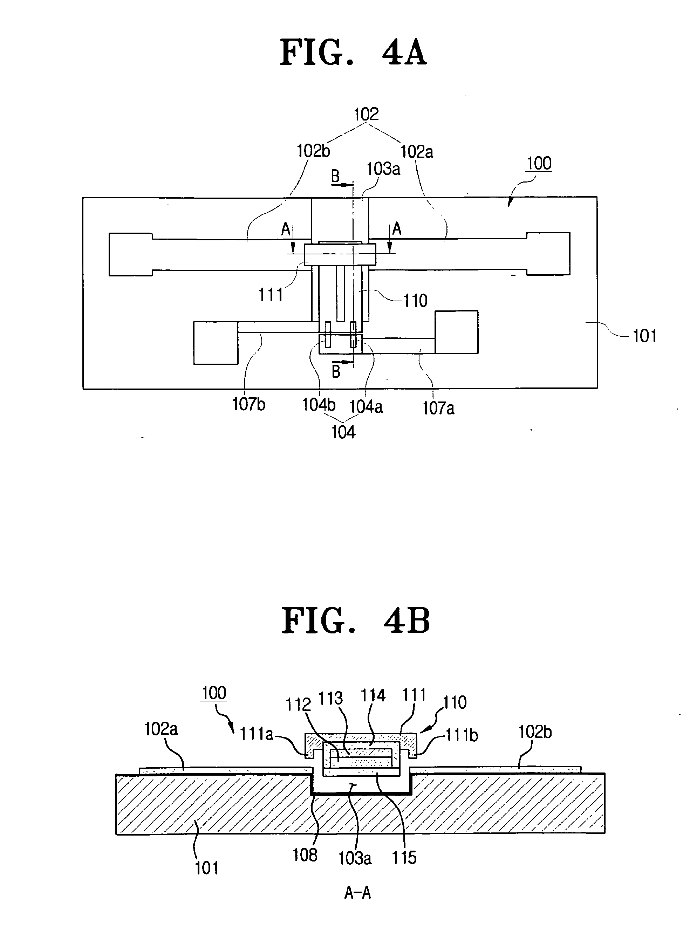

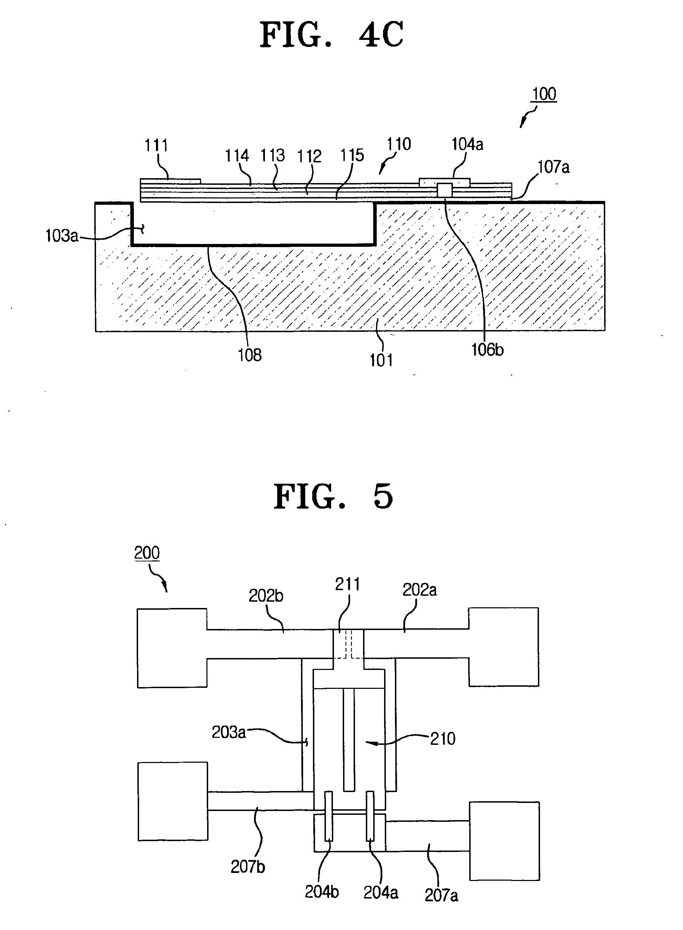

FIG. 3 is a perspective view illustrating a down driven RF MEMS switch according to the first exemplary embodiment of the present invention, FIG. 4A is a plan view of FIG. 3, FIG. 4B is a sectional view taken along line A-A of FIG. 4A, and FIG. 4C is a sectional view taken along line B-B of FIG. 4A.

As shown in FIG. 3 and FIG. 4A to FIG. 4C, the RF MEMS switch 100 according to the first exemplary embodiment of the present invention includes a substrate 101 provided with an RF signal line 102 and a cavity 103a, a cantilever 110 positioned on the cavity 103a, having one end fixed to the substrate 101, and a contact pad 111 connecting the RF signal line 102 with the cantilever 110 in contact with the RF signal line 102 when the cantilever 110 is down driven.

The substrate 101 may be provided with a CPW line on an upper surface, which includes the RF signal line 102 and DC driving lines 107a and 107b. A cavity 103a is formed in the substrate 101 by an etching process. In an exemplary embodiment, the cavity 103a is positioned between the RF input signal line 102a and the RF output signal line 102B. However, in RF MEMS switches according to other exemplary embodiments (see FIG. 5 to FIG. 7), the RF signal line 102 may be positioned in front of the cavity 103a.

The RF signal line 102 may be comprised of the RF input signal line 102a and the RF output signal line 102b. In an exemplary embodiment, the RF signal line 102 is formed below the contact pad 111. In the RF MEMS switch 100 according to the first exemplary embodiment of the present invention, both ends 111 a and 111b of the contact pad 111 respectively contact the RF input signal line 102a and the RF output signal line 102a in accordance with down driving of the cantilever 110 to transmit the RF signal to the RF signal line 102.

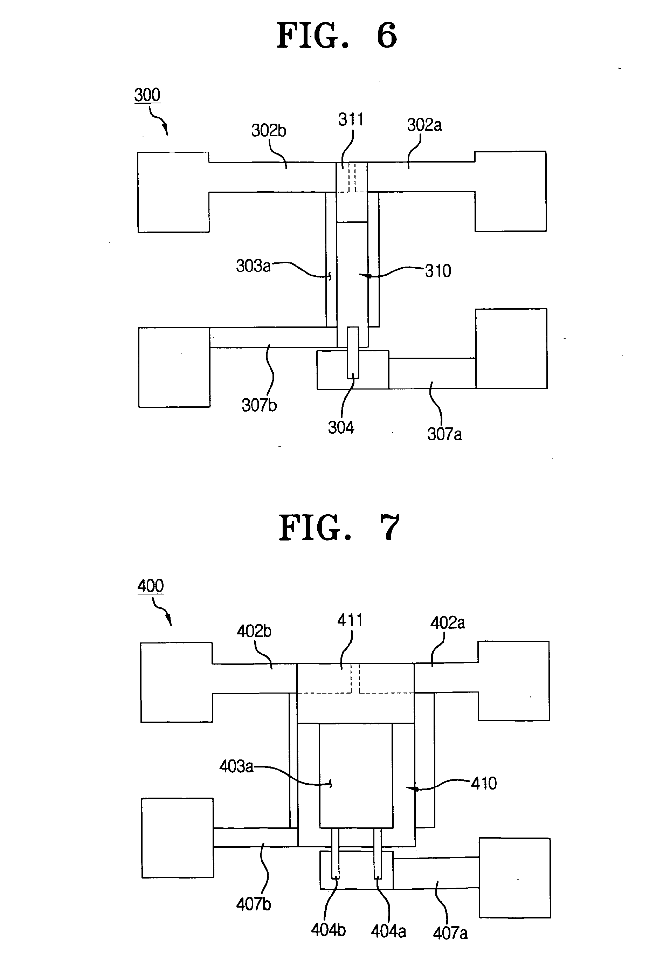

The cantilever 110 may be comprised of one beam (see FIG. 6) or a pair of beams. In an exemplary embodiment, the cantilever 110 is provided with the lower electrode 115, the piezoelectric layer 112, the upper electrode 113, and the membrane 114 in due order from a down direction.

The upper electrode 113 and the lower electrode 115 are respectively connected with the driving lines 107a and 107b by upper terminal electrodes 104a and 104b and lower terminal electrodes 106a and 106b.

The membrane 114 is formed along the longitudinal direction of the cantilever 110. The membrane 114 covers the upper electrode 113 and the piezoelectric layer 112 but opens the lower electrode 115. The cantilever 110 can be down driven by such a structure of the membrane 114.

In an exemplary embodiment, the contact pad 111 is formed on the upper end of the cantilever 110. In the RF MEMS switches according to the other exemplary embodiments (see FIG. 5 to FIG. 7), contact pads 211, 311 and 411 may be projected along a longitudinal direction of cantilevers 210, 310, and 410, respectively.

In the RF MEMS switch 100 of the exemplary embodiment of the present invention, a passivation layer 108 may further be formed on the surface of the cavity 103a.

FIG. 5 to FIG. 7 are plan views illustrating RF MEMS switches according to the other exemplary embodiments. The RF MEMS switches shown in FIG. 5 to FIG. 7 are different from the RF MEMS switch 100 of the first exemplary embodiment in contact pads or cantilevers. For understanding, since the same reference numbers will be used throughout the drawings to refer to the same or like parts, their repeated description will be omitted.

Unlike the RF MEMS switch 100 according to the first exemplary embodiment of the present invention, the RF MEMS switch 200 according to the second exemplary embodiment, shown in FIG. 5, has a structure that the contact pad 211 is more projected than the cavity 203a. In the RF MEMS switch 200 constructed as above, since the contact distance between RF signal lines 202a and 202b and the contact pad 211 is long, the maximum displacement of the cantilever 210 can be used. Therefore, the RF MEMS switch 200 may have excellent isolation property required for RF characteristics.

Unlike the RF MEMS switch 100 according to the first exemplary embodiment of the present invention, the RF MEMS switch 300 shown in FIG. 6 in accordance with the third exemplary embodiment is provided with a cantilever 310 having one beam. As a result, the RF MEMS switch 300 according to the third exemplary embodiment can readily be fabricated and has a small package area due to a small size.

Unlike the RF MEMS switch 100 according to the first exemplary embodiment of the present invention, the RF MEMS switch 400 shown in FIG. 7 in accordance with the fourth exemplary embodiment has a structure that the distance between beams of a cantilever 410 is relatively wide and thus a contact pad 411 has a large size. In the RF MEMS switch 400 as constructed as above, since RF signal lines 402a and 402b stably contact the contact pad 411, reliability in RF signal transmission would be high.

The operation of the RF MEMS switch 100 according to the first exemplary embodiment of the present invention will be described with reference to the accompanying drawings.

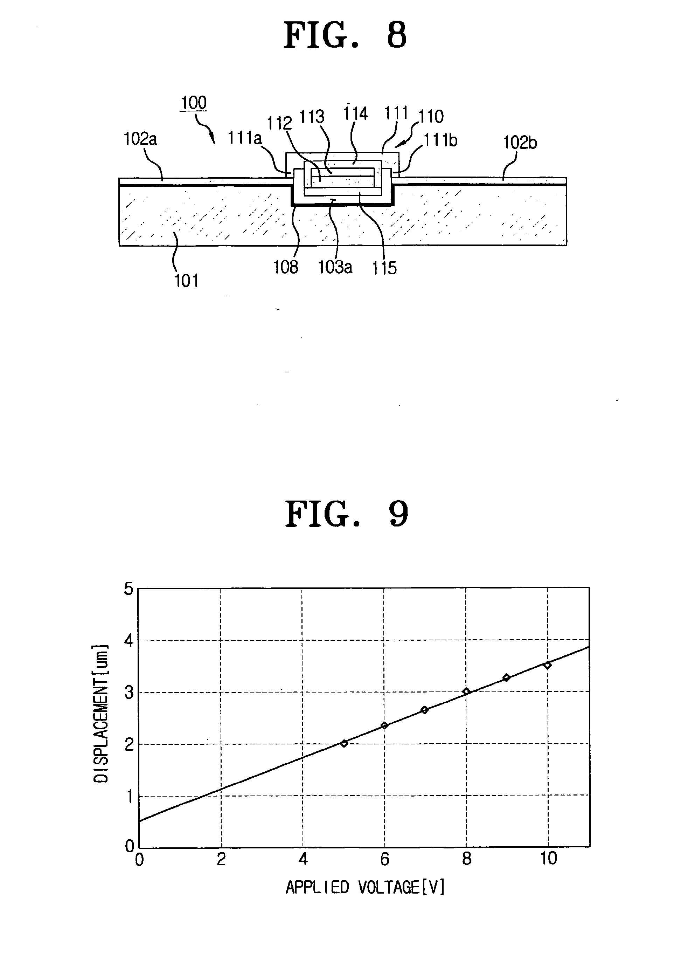

FIG. 8 illustrates the operation of the RF MEMS switch 100 according to the first exemplary embodiment of the present invention. If the DC voltage is applied to the RF MEMS switch 100 through the driving lines 107a and 107b (see FIG. 3) as shown in FIG. 4B, the DC voltage is applied to the upper and lower electrodes 113 and 115 through the upper and lower terminal electrodes 104a, 104b, 106a, 106b, respectively (see FIG. 3) connected with the driving lines 107a and 107b (see FIG. 3). At the same time, polarization occurs in the piezoelectric layer 112 of the cantilever 110, and force is applied to the cantilever 110. Since the membrane 114 is positioned on the cantilever 110, the cantilever 110 is down driven in the cavity 103a as shown in FIG. 8. In other words, dipole moment occurs in the cantilever 110 as the voltage is applied to the piezoelectric thin film material constituting the membrane 114, whereby the cantilever 110 is down bent. Both ends 111a and 111b of the contact pad 111 positioned in the cantilever 110 contact the RF signal lines 102a and 102b formed in the substrate 101 through switching of the cantilever 110, and the RF signal passes through the substrate 101.

FIG. 9 is a graph illustrating a displacement relation between the voltage applied to the RF MEMS device 100 and the cantilever 110. As shown in FIG. 9, it is noted that the cantilever 110 is well driven in the RF MEMS device 100 in accordance with the DC voltage. For example, since displacement of 1.5µm to 2.0µm is obtained at a voltage of 3V to 5V, the RF MEMS device 100 can stably be operated at a low voltage.

Hereinafter, a method for fabricating the RF MEMS switch according to the exemplary embodiment of the present invention will be described with reference to the accompanying drawings.

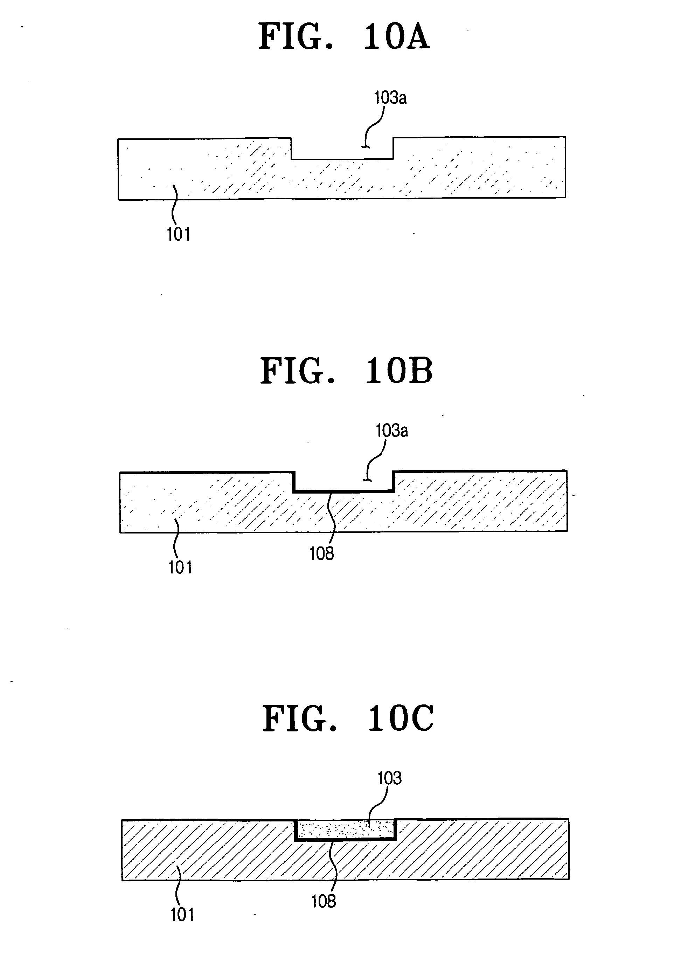

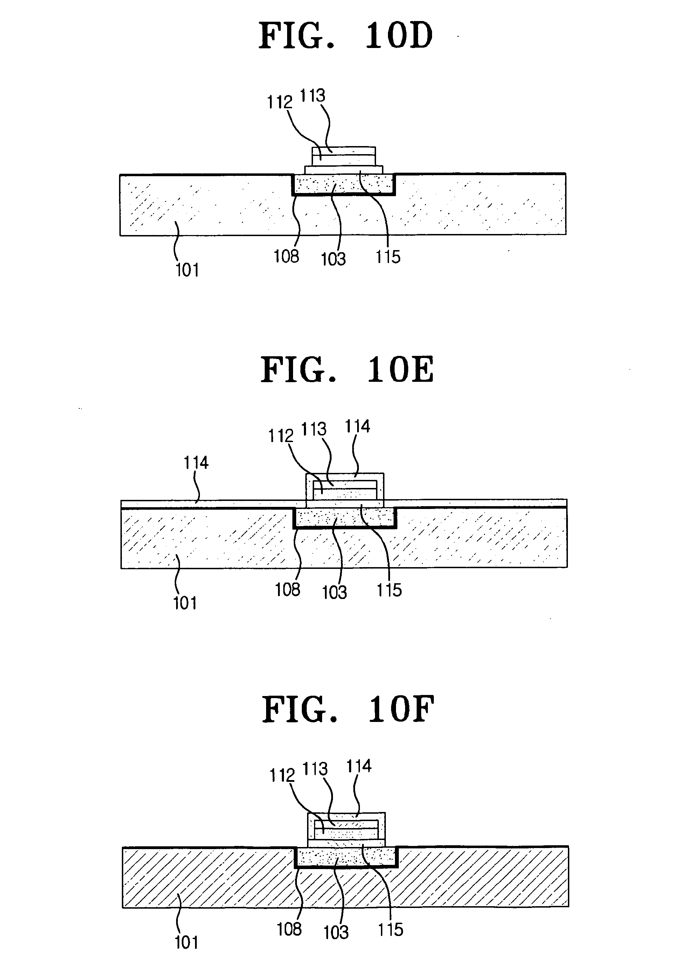

FIG. 10A to FIG. 10L are sectional views illustrating a method for fabricating the RF MEMS switch 100 according to the exemplary embodiment of the present invention.

The method for fabricating the piezoelectric RF MEMS device 100 according to the first exemplary embodiment of the present invention is not different from the methods for fabricating the RF MEMS switches according to the second exemplary embodiment to the fourth exemplary embodiment of the present invention in a patterning process. Therefore, a repeated description for the methods for fabricating the RF MEMS switches according to the second exemplary embodiment to the fourth exemplary embodiment will not be described.

To fabricate the RF MEMS switch 100 according to the first exemplary embodiment of the present invention, the substrate 101 having the cavity 103a is prepared (FIG. 10A). The cavity 103a of the substrate 101 may be formed by a typical etching process. A silicon wafer such as a high resistance silicon wafer or a high purity silicon wafer, a glass based wafer such as a fused silica, or a quart wafer may be used as the substrate 101.

Then, the cantilever 110 is formed in the substrate 101 provided with the cavity 103a (FIG. 10A to FIG. 10F).

To fabricate the cantilever 110, the passivation layer 108 is formed on the surface of the substrate 101 including the etched cavity 103a by a typical deposition process and then patterned (FIG. 10B). Silicon oxide such as SiO₂ or silicon nitride such as Si₃N₄ may be used as the passivation layer 108.

Subsequently, a first sacrificing layer 103 is formed in the cavity 103a and then patterned by a chemical mechanical polishing (CMP) process (FIG. 10C). The first sacrificing layer 103 may be formed of polysilicon, LTO, TEOS, polymer for photoresist, metal, or alloy.

The lower electrode layer 115, the piezoelectric layer 112, the upper electrode layer 113 and the membrane layer 114 are sequentially deposited on the first sacrificing layer 103 and then sequentially patterned (FIG. 10D to FIG. 10F). In this case, the cantilever 110 may be comprised of one or two or more beams in accordance with patterning.

The upper electrode 113 and the lower electrode 115 may be formed of Pt, Rh, Ta, Au, Mo or AuPt. In an exemplary embodiment, the upper electrode 113 and the lower electrode 115 may be formed of Pt. Since Pt has a high melting point, diffusion or silicide does not occur when the piezoelectric layer is sintered if Pt is used as the upper electrode 113 or the lower electrode 115.

The piezoelectric layer 112 may be formed of a piezoelectric material such as PZT, barium titanate, ITO, zinc oxide, and aluminum nitride. In an exemplary embodiment, the piezoelectric layer 112 may be formed of PZT.

The membrane layer 114 may be formed of silicon nitride, aluminum nitride, polysilicon oxide, TEOS, Mo, Ta, Pt, or Rh.

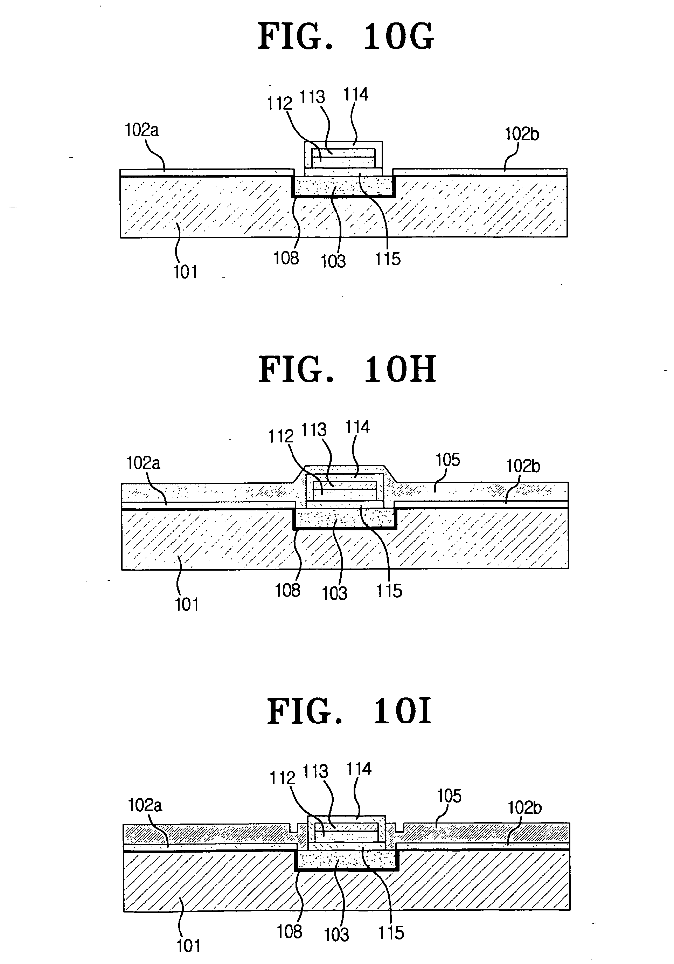

Next, the RF signal lines 102a and 102b are formed in the substrate 101 provided with the cavity 103a (FIG. 10G). The RF signal line 102 is generally formed of Au but may be formed of Rh, Ti, Ta, Pt, or AuNix.

The RF signal line 102 is formed of metal while the piezoelectric material for the cantilever 110 is formed of ceramic. Therefore, the CPW line such as the RF signal line 102 should be formed in the substrate 101 before the cantilever 110 is formed. Since the membrane layer 114 or the piezoelectric layer 112 of a piezoelectric thin film material is fabricated at a high temperature, it is impossible to form the RF signal line below the cantilever 110 in the related art. That is, since the RF MEMS switch that drives the piezoelectric material using a driving mechanism is up driven, the CPW line should be formed above the cantilever.

However, in the exemplary embodiment of the present invention, the CPW line such as the RF signal line 102 or the driving line 107 can be formed to be lower than the cantilever 110. Particularly, since signal lines are formed after the membrane layer 114 is formed, the piezoelectric thin film material can be sintered by the above process order. As a result, it is possible to obtain optimized mechanical displacement of the piezoelectric material. Also, the maximum displacement can be generated by the minimum voltage. Furthermore, in the exemplary embodiment of the present invention, since the cantilever 110 and the RF signal line 102 are formed in one substrate 101, no separate upper substrate is required. Instead, different CPW lines are formed in one substrate in the exemplary embodiment of the present invention. This means that the RF MEMS switch can stably and simply be fabricated.

Afterwards, the contact pad 111 is formed on the upper end of the cantilever 110 (FIG. 10H to FIG. 10J).

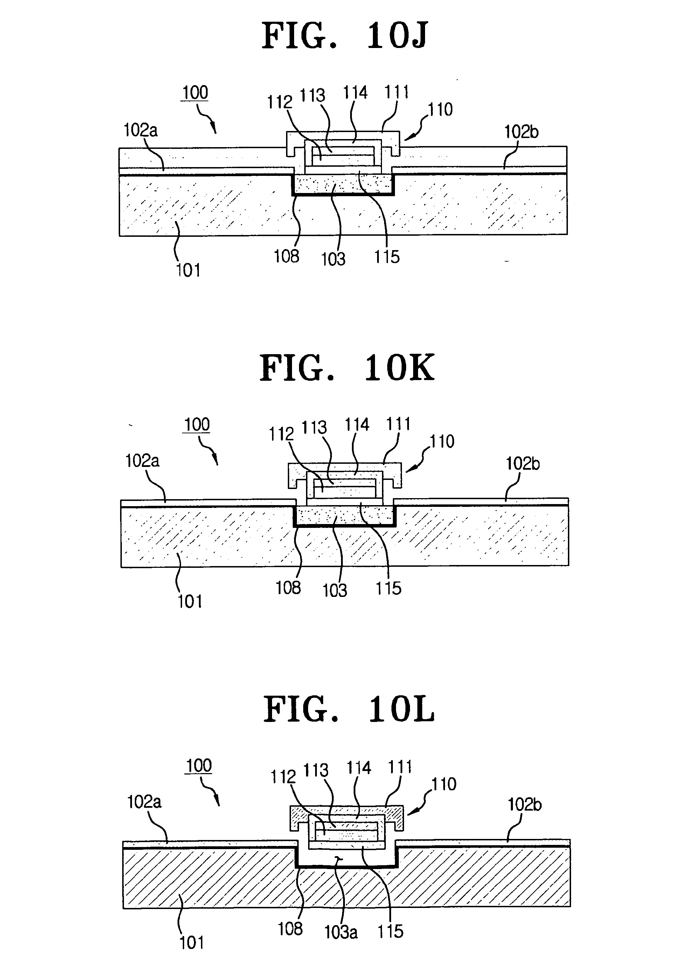

To form the contact pad 111, a second sacrificing layer 105 is deposited on the first substrate 101 provided with the RF signal line 102 (FIG. 10H). In this case, a gap between the RF signal line 102 and the contact pad 111 can be controlled by the thickness of the second sacrificing layer 105. The second sacrificing layer 105 may be formed of polysilicon, LTO, TEOS, polymer for photoresist, metal, or alloy. After the second sacrificing layer 105 is patterned to expose the cantilever 110 (FIG. 10I), the contact pad 111 is formed on the upper end of the cantilever 110 (FIG. 10J). Then, the second sacrificing layer 105 and the first sacrificing layer 103 are sequentially removed from the substrate 101 (FIG. 10K and FIG. 10L). The cantilever 110 of the RF MEMS switch from which the first and second sacrificing layers 103 and 105, respectively, are removed has a floating structure. Therefore, if the DC voltage is applied from the driving lines 107a and 107b to the cantilever 110, the cantilever 110 is down bent to contact the contact pad 111 with the RF signal line 102 so that the RF signal can be transmitted.

As described above, in the piezoelectric RF MEMS switch of the exemplary embodiment of the present invention, the CPW line and the piezoelectric cantilever can be formed in one substrate, and the CPW line can be formed to be lower than the piezoelectric cantilever. Also, since the RF MEMS switch has a simple structure, it is possible to achieve miniaturization of the part.

Further, the RF MEMS switch of the exemplary embodiment of the present invention can stably be operated at a lower driving voltage without power consumption. Moreover, the RF MEMS switch can stably be fabricated in accordance with the fabricating method according to the exemplary embodiment of the present invention.

## Claims

1. A method for fabricating a radio frequency microelectromechanical system (hereinafter "RF MEMS") switch comprising:
forming a cavity (103a) in a substrate (101);
fabricating a cantilever (110) on the cavity;
forming RF signal lines (102) in the substrate provided with the cavity; and
forming a contact pad (111) on the cantilever,
wherein fabricating the cantilever (110) comprises:
forming a passivation layer (108) on the substrate;
forming a first sacrificing layer (103) in the cavity; and
sequentially forming a lower electrode layer (115), a ceramic piezoelectric layer (112), an upper electrode layer (113), and a membrane layer (114) on the first sacrificing layer and patterning the lower electrode layer, the piezoelectric layer, the upper electrode layer, and the membrane layer.

2. The method as claimed in claim 1, wherein forming the cavity (103a) comprises an etching process.

3. The method as claimed in claim 1 or 2, wherein the RF signal lines (102) are formed of one of gold, rhodium, titanium, tantalum, platinum, and gold/nickel alloy.

4. The method as claimed in any one of claims 1 to 3, wherein the contact pad (111) is formed on an upper end of the cantilever.

5. The method as claimed in claim 1, wherein the passivation layer (108) is formed of silicon oxide or silicon nitride.

6. The method as claimed in claim 1 or 5, wherein the first sacrificing layer (103) is formed of any one of polysilicon, low temperature oxide, Tetraethylorthosilicate, polymer for photoresist, metal, and alloy.

7. The method as claimed in any one of claims 1, 5 or 6, wherein the upper electrode (113) and the lower electrode (115) are formed of any one of platinum, rhodium, tantalum, gold, molybdenum and gold/platinum.

8. The method as claimed in any one of claims 1 or 5 to 7, wherein the piezoelectric layer (112) is formed of a piezoelectric material such as lead zirconate titanate, barium titanate, indium tin oxide, zinc oxide, and aluminum nitride.

9. The method as claimed in any one of claims 1 or 5 to 8, wherein the membrane layer (114) is formed of one of silicon nitride, aluminum nitride, polysilicon oxide, Tetraethylorthosilicate, molybdenum, tantalum, platinum, and rhodium.

10. The method as claimed in any one of claims 1 or 5 to 9, wherein the forming the contact pad comprises:
depositing a second sacrificing layer (105) on the substrate provided with the RF signal lines and patterning the second sacrificing layer;
forming the contact pad on the cantilever on the patterned sacrificing layer; and
removing the first and second sacrificing layers (103, 105).

11. The method as claimed in claim 10, wherein a gap between the RF signal lines and the contact pad is controlled by the thickness of the second sacrificing layer (105).

12. The method as claimed in claim 10 or 11, wherein the second sacrificing layer (105) is formed of one of polysilicon, low temperature oxide, Tetraethylorthosilicate, polymer for photoresist, metal, and alloy.

## Patentansprüche

1. Verfahren zur Herstellung eines mikroelektromechanischen Radiofrequenzsystem- (nachfolgend "RF MEMS" genannt) Schalters, das Folgendes beinhaltet:
Ausbilden eines Hohlraums (103a) in einem Substrat (101);
Herstellen eines Cantilevers (110) an dem Hohlraum;
Ausbilden von RF-Signalleitungen (102) in dem mit dem Hohlraum versehenen Substrat; und
Bilden einer Kontaktstelle (111) an dem Cantilever,
wobei das Herstellen des Cantilevers (110) Folgendes beinhaltet:
Ausbilden einer Passivierungsschicht (108) auf dem Substrat;
Ausbilden einer ersten Opferschicht (103) in dem Hohlraum; und
nachfolgendes Ausbilden einer unteren Elektrodenschicht (115), einer piezoelektrischen Keramikschicht (112), einer oberen Elektrodenschicht (113) und einer Membranschicht (114) auf der ersten Opferschicht und Strukturieren der unteren Elektrodenschicht, der piezoelektrischen Schicht, der oberen Elektrodenschicht und der Membranschicht.

2. Verfahren nach Anspruch 1, wobei das Bilden des Hohlraums (103a) einen Ätzprozess beinhaltet.

3. Verfahren nach Anspruch 1 oder 2, wobei die RF-Signalleitungen (102) aus einer Gold-, Rhodium-, Titan-, Tantal-, Platin- oder Gold/Nickel-Legierung gebildet sind.

4. Verfahren nach einem der Ansprüche 1 bis 3, wobei die Kontaktstelle (111) an einem oberen Ende des Cantilevers ausgebildet ist.

5. Verfahren nach Anspruch 1, wobei die Passivierungsschicht (108) aus Siliciumoxid oder Siliciumnitrid gebildet wird.

6. Verfahren nach Anspruch 1 oder 5, wobei die erste Opferschicht (103) aus Polysilicium, Niedertemperaturoxid, Tetraethylorthosilicat, Polymer für Photoresist, Metall oder Legierung gebildet wird.

7. Verfahren nach Anspruch 1, 5 oder 6, wobei die obere Elektrode (112) und die untere Elektrode (115) aus Platin, Rhodium, Tantal, Gold, Molybdän oder Gold/Platin gebildet werden.

8. Verfahren nach einem der Ansprüche 1 oder 5 bis 7, wobei die piezoelektrische Schicht (112) aus einem piezoelektrischen Material wie Blei-Zirkonat-Titanat, Bariumtitanat, Indiumzinnoxid, Zinkoxid und Aluminiumnitrid gebildet ist.

9. Verfahren nach nach einem der Ansprüche 1 oder 5 bis 8, wobei die Membranschicht (114) aus Siliciumnitrid, Aluminiumnitrid, Polysiliciumoxid, Tetraethylorthosilicat, Molybdän, Tantal, Platin oder Rhodium gebildet ist.

10. Verfahren nach nach einem der Ansprüche 1 oder 5 bis 9, wobei das Ausbilden der Kontaktstelle Folgendes beinhaltet:
Aufbringen einer zweiten Opferschicht (105) auf das Substrat mit den RF-Signalleitungen und Strukturieren der zweiten Opferschicht;
Ausbilden der Kontaktstelle auf dem Cantilever auf der strukturierten Opferschicht; und
Entfernen der ersten und der zweiten Opferschicht (103, 105).

11. Verfahren nach Anspruch 10, bei dem eine Lücke zwischen den RF-Signalleitungen und der Kontaktstelle durch die Dicke der zweiten Opferschicht (105) reguliert wird.

12. Verfahren nach Anspruch 10 oder 11, bei dem die zweite Opferschicht (105) aus Polysilicium, Niedertemperaturoxid, Tetraethylorthosilicat, Polymer für Photoresist, Metall oder Legierung gebildet wird.

## Revendications

1. Procédé de fabrication d'un commutateur de système micro électromécanique pour la radio fréquence (ci-après « RF MEMS ») comprenant les étapes consistant à :
former une cavité (103a) dans un substrat (101) ;
fabriquer une console (110) sur la cavité ;
former des lignes de signaux RF (102) dans le substrat fourni avec la cavité ; et
former une pastille de contact (111) sur la console,
dans lequel la fabrication de la console (110) comprend les étapes consistant à :
former une couche de passivation (108) sur le substrat ;
former une première couche sacrificielle (103) dans la cavité ; et
former séquentiellement une couche d'électrode inférieure (115), une couche piézoélectrique en céramique (112), une couche d'électrode supérieure (113), et une couche membranaire (114) sur la première couche sacrificielle et mettre en relief la couche d'électrode inférieure, la couche piézoélectrique, la couche d'électrode supérieure, et la couche membranaire.

2. Procédé tel que revendiqué à la revendication 1, dans lequel l'étape consistant à former une cavité (103a) comprend un processus de gravure.

3. Procédé tel que revendiqué à la revendication 1 ou à la revendication 2, dans lequel les lignes de signaux RF (102) sont formées d'un parmi de l'or, du rhodium, du titane, du tantale, du platine et un alliage or/nickel.

4. Procédé tel que revendiqué dans l'une quelconque des revendications 1 à 3, dans lequel la pastille de contact (111) est formée sur une extrémité supérieure de la console.

5. Procédé tel que revendiqué à la revendication 1, dans lequel la couche de passivation (108) est formée d'oxyde de silicium ou de nitrure de silicium.

6. Procédé tel que revendiqué à la revendication 1 ou à la revendication 5, dans lequel la première couche sacrificielle (103) est formée de l'un quelconque parmi du polysilicium, un oxyde basse température, du tétraéthylorthosilicate, un polymère pour résine photosensible, un métal, et un alliage.

7. Procédé tel que revendiqué dans l'une quelconque des revendications 1, 5 ou 6, dans lequel l'électrode supérieure (113) et l'électrode inférieure (115) sont formées d'un parmi du platine, du rhodium, du tantale, de l'or, du molybdène, et de l'or/platine.

8. Procédé tel que revendiqué dans l'une quelconque des revendications 1 ou 5 à 7, dans lequel la couche piézoélectrique (112) est formée d'un matériau piézoélectrique tel que du titano-zirconate de plomb, du titanate de baryum, de l'oxyde d'étain et d'indium, de l'oxyde de zinc et du nitrure d'aluminium.

9. Procédé tel que revendiqué dans l'une quelconque des revendications 1 ou 5 à 8, dans lequel la couche membranaire (114) est formée d'un parmi du nitrure de silicium, du nitrure d'aluminium, de l'oxyde de polysilicium, du tétraéthylorthosilicate, du molybdène, du tantale, du platine, et du rhodium.

10. Procédé tel que revendiqué dans l'une quelconque des revendications 1 ou 5 à 9, dans lequel la formation de la pastille de contact comprend les étapes consistant à :
déposer une deuxième couche sacrificielle (105) sur le substrat fourni avec les lignes de signaux RF et mettre en relief la deuxième couche sacrificielle ;
former une pastille de contact sur la console sur la couche sacrificielle mise en relief ; et
éliminer les première et deuxième couches sacrificielles (103, 105).

11. Procédé tel que revendiqué à la revendication 10, dans lequel un espace entre les lignes de signaux RF et la pastille de contact est contrôlé par l'épaisseur de la deuxième couche sacrificielle (105).

12. Procédé tel que revendiqué à la revendication 10 ou à la revendication 11, dans lequel la deuxième couche sacrificielle est formée d'un parmi du polysilicium, un oxyde basse température, du tétraéthylorthosilicate, un polymère pour résine photosensible, un métal, et un alliage.
